# EUROPEAN PATENT APPLICATION

(11) **EP 4 050 795 A1**
(43) Date of publication of application: **31.08.2022**
(21) Application number: 20880234.8
(22) Date of filing: 06.05.2020
(51) Int. Cl.: H03H 9/17

(54) **BULK ACOUSTIC RESONATOR, FILTER, AND ELECTRONIC DEVICE**

(30) Priority: 26.10.2019 CN 201911027017
(71) Applicant: Rofs Microsystem (Tianjin) Co., Ltd, Tianjin 300462 (CN)
(72) Inventor: PANG, Wei, Tianjin 300072 (CN); YANG, Qingrui, Tianjin 300072 (CN); ZHANG, Menglun, Tianjin 300072 (CN); XU, Yang, Tianjin 300462 (CN)
(74) Representative: Meyer-Dulheuer MD Legal Patentanwälte PartG mbB
(86) International application number: PCT/CN2020/088666
(87) International publication number: WO 2021/077716

(57) **Abstract**

Disclosed is a bulk acoustic resonator, which includes: a base, an acoustic mirror cavity provided in the base, a bottom electrode, a top electrode, and a piezoelectric layer provided between the bottom electrode and the top electrode, wherein the bottom electrode includes a first bottom electrode and a second bottom electrode, the first bottom electrode is provided above the acoustic mirror cavity, and at least part of the second bottom electrode is provided in the acoustic mirror cavity to form a gap with the first bottom electrode, and the second bottom electrode also maintains electrical contact with the first bottom electrode. Further disclosed are a filter having the resonator and an electronic device having the filter or the resonator.

## Description

### TECHNICAL FIELD

The present disclosure relates to the field of semiconductors, and in particular, to a bulk acoustic wave resonator, a filter having the resonator, and an electronic device having the resonator or the filter.

### BACKGROUND

Electronic components have been widely used as basic elements of electronic devices, applications of which include mobile phones, vehicles, household appliances and so on. In addition, technologies such as artificial intelligence, Internet of Things and 5G communications that will change the world in the future still need to rely on the electronic components as foundations.

A film bulk acoustic resonator (FBAR, also referred to as Bulk Acoustic Wave Resonator, BAW), as an important member of the piezoelectric devices, is important in the field of communications. In particular, FBAR filters have an increasing market in the field of radio frequency (RF) filters. The FBAR has excellent characteristics such as small size, high resonant frequency, high quality factor, large power capacity, and good roll-off effect. The filters of FBAR are gradually replacing traditional surface acoustic wave (SAW) filters and ceramic filters. The filters of FBAR play a huge role in the field of wireless communication radio frequency, and the high sensitivity advantage thereof can be applied to biological, physical, medical and other sensing fields.

The structural main body of the film bulk acoustic wave resonator is a "sandwich" structure composed of electrode-piezoelectric film-electrode, that is, a piezoelectric material is sandwiched between two metal electrode layers. By inputting a sinusoidal signal between the two electrodes, the FBAR converts the input electrical signal into mechanical resonance by the inverse piezoelectric effect, and converts the mechanical resonance into an electrical signal for output by the piezoelectric effect.

As the working frequency of the filter increase constantly, the film thickness of the bulk acoustic wave resonator, especially the film thickness of the electrode, is required to be further reduced, resulting in an increase in electrical loss and a decrease in a Q value in the vicinity of a series resonance point of the resonator and the frequency thereof. Therefore, it is required for a low electrical loss bulk acoustic wave resonator with simple processing technology and reliable performance.

### SUMMARY

The present disclosure is provided to alleviate or solve the above problems in the prior art.

According to one aspect of embodiments of the present disclosure, a bulk acoustic wave resonator is provided. The bulk acoustic wave resonator includes a substrate, an acoustic mirror cavity provided in the substrate, a bottom electrode, a top electrode, and a piezoelectric layer provided between the bottom electrode and the top electrode. The bottom electrode includes a first bottom electrode and a second bottom electrode, the first bottom electrode is provided above the acoustic mirror cavity. At least part of the second bottom electrode is provided in the acoustic mirror cavity to form a gap between the second bottom electrode and the first bottom electrode, and the second bottom electrode maintains electrical contact with the first bottom electrode.

The embodiments of the present disclosure also relate to a filter including the above bulk acoustic wave resonator.

The embodiments of the present disclosure also relate to an electronic device including the above filter or the above resonator.

### BRIEF DESCRIPTION OF DRAWINGS

The following description and drawings can help understand these and other features and advantages in various embodiments of the present disclosure, and the same reference signs in the drawings always indicate the same components, wherein:
Fig. 1 is a schematic top view of a bulk acoustic wave resonator according to an exemplary embodiment of the present disclosure;
Fig. 1A is a schematic sectional view along line A1-A2 in Fig. 1 according to an exemplary embodiment of the present disclosure;
Fig. 1B is a schematic sectional view along line A1-A2 in Fig. 1 according to another exemplary embodiment of the present disclosure, wherein a heat dissipation path is further shown;
Fig. 1C is a schematic sectional view along line A1-A2 in Fig. 1 according to another exemplary embodiment of the present disclosure, wherein the deformation of the resonator under stress is further shown;
Fig. 1D is a schematic sectional view along line A1-A2 in Fig. 1 according to another exemplary embodiment of the present disclosure;
Fig. 2 is a schematic sectional view along line A1-A2 in Fig. 1 according to yet another exemplary embodiment of the present disclosure;
Fig. 3 is a schematic sectional view along line A1-A2 in Fig. 1 according to yet another exemplary embodiment of the present disclosure;
Fig. 4A is a schematic sectional view along line A1-A2 in Fig. 1 according to yet another exemplary embodiment of the present disclosure, wherein a first bottom electrode is provided with a through hole;
Fig. 4B is a schematic sectional view along line A1-A2 in Fig. 1 according to an exemplary embodiment of the present disclosure, wherein a first bottom electrode and a piezoelectric layer are provided with through holes;
Fig. 4C is a schematic sectional view along line A1-A2 in Fig. 1 according to still another exemplary embodiment of the present disclosure, wherein a through hole is formed outside the first bottom electrode and is connected to a release channel of an acoustic mirror cavity, and a second bottom electrode is provided only in the cavity of the acoustic mirror cavity; and
Fig. 4D is a schematic sectional view along line A1-A2 in Fig. 1 according to another exemplary embodiment of the present disclosure, wherein a second bottom electrode and a substrate are provided with through holes.

### DESCRIPTION OF EMBODIMENTS

The technical solutions of the present disclosure will be further described in detail below through embodiments and in conjunction with the drawings. In the specification, the same or similar reference signs refer to the same or similar components. The following description of the embodiments of the present disclosure with reference to the drawings is intended to explain the general inventive concept of the present disclosure, and should not be construed as a limitation to the present disclosure.

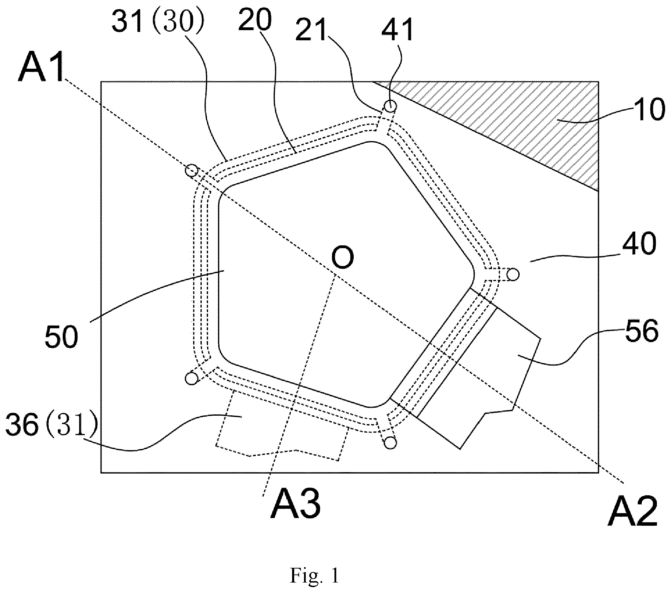

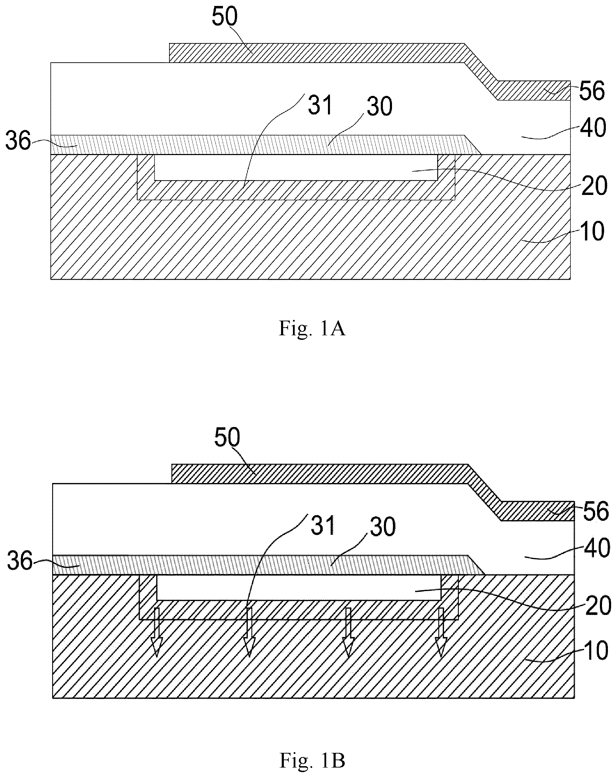

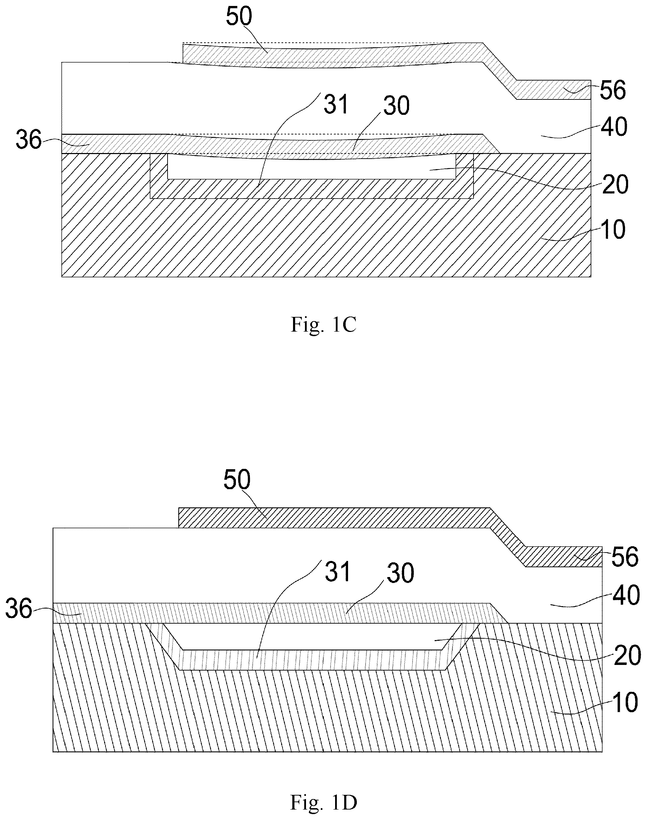

Fig. 1 is a schematic top view of a bulk acoustic wave resonator according to an exemplary embodiment of the present disclosure. In Fig. 1, the reference signs are described as follows:
10: a substrate typically made of silicon (high-resistance silicon), gallium arsenide, sapphire, quartz or the like;
20: an acoustic mirror cavity;
30: a first bottom electrode, a material of which is selected from molybdenum, ruthenium, gold, aluminum, magnesium, tungsten, copper, titanium, iridium, osmium or chromium, or a compound or an alloy thereof;
36: an electrode pin, a material of which is the same as that of the first bottom electrode;
31: a second bottom electrode, a material of which is selected from the same material range as that of the first bottom electrode 30, but the material may not be the same as that of the first bottom electrode 30;
40: a piezoelectric film layer, which may be made of aluminum nitride (AlN), zinc oxide (ZnO), lead zirconate titanate (PZT), lithium niobate (LiNbO₃), quartz, potassium niobate (KNbO₃), lithium tantalate (LiTaO₃) or the like, and may contain rare earth element doped materials with a certain atomic ratio of the above materials;
50: a first top electrode, which may be made of molybdenum, ruthenium, gold, aluminum, magnesium, tungsten, copper, titanium, iridium, osmium or chromium, or a compound or an alloy thereof;
56: an electrode pin, a material of which is the same as that of the first top electrode;
21: a sacrificial layer release channel; and
41: a sacrificial layer release hole.

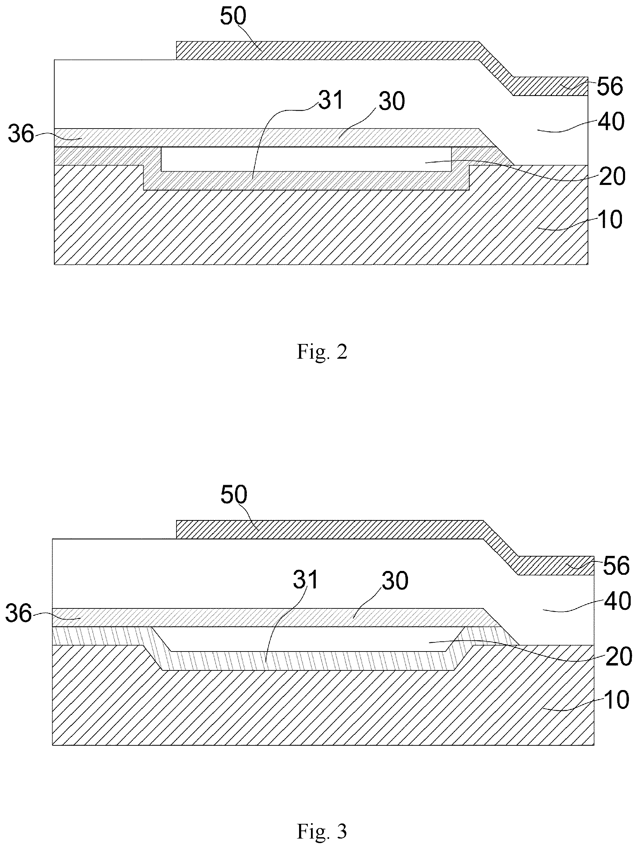

Further, as shown in Fig. 1A and Fig. 2 respectively, when the bottom electrode includes the first bottom electrode 30 and the second bottom electrode 31, which are in electrical contact with each other and have an air gap structure therebetween. In order to effectively increase the gap, in the present disclosure, the second bottom electrode 31 can be partially or completely provided in the acoustic mirror cavity 20, thereby effectively increasing the gap.

As shown in Fig. 1A, in a preferred embodiment, the second bottom electrode 31 is laid on a bottom of a cavity-type acoustic mirror 20. In another preferred embodiment, the cavity-type acoustic mirror 20 further includes a sidewall, the second bottom electrode 31 not only covers the bottom of the cavity-type acoustic mirror 20, but also is further laid on the sidewall of the cavity-type acoustic mirror 20. Meanwhile, both ends of the second bottom electrode 31 are maintained in electrical contact with the first bottom electrode 30, that is, the second bottom electrode is connected in parallel on the basis of the first bottom electrode. Accordingly, the electrode loss is greatly reduced, thereby improving a Q value of the resonator in the vicinity of series resonance frequency. Further, the gap between the second bottom electrode and the first bottom electrode can achieve an acoustic isolation effect, and therefore other properties of the resonator, such as electromechanical coupling coefficient and the Q value in the vicinity of parallel resonance frequency, will not be subjected to any negative effect.

As shown in Fig. 1B, when the resonator operates, the heat generated in an effective region is effectively dissipated into the substrate 10 by means of the second bottom electrode 31. That is, the above structure can effectively increase a contact area between the bottom electrode and the substrate 10, thereby improving the heat dissipation efficiency and the power capacity (heat dissipation paths are clearly shown by arrows in Fig. 1B).

Furthermore, as shown in Fig. 1C (dotted lines respectively show the deformation of the top electrode 50 and the first bottom electrode 30), when the sandwich structure of the resonator is bent under a stress action, the air gap formed by the cavity 20 provides a sufficient space to prevent the bottom electrodes 30 and 31 from contacting each other. That is, the above structure can effectively increase the air gap 20 between two layers of the bottom electrodes, thereby reducing a probability of bending and attaching of the two layers of electrodes under the stress action, thus enhancing the performance reliability and process stability of the resonator. In addition, the structure can be made of a simpler release structure, thereby simplifying the process.

Further optionally, in order to make the second bottom electrode have good adhesion and continuity on the sidewall of the acoustic mirror cavity, the sidewall of the acoustic mirror cavity is processed into a slope shape, as shown in Fig. 1D.

Furthermore, as shown in Figs. 2 and 3, the second bottom electrode 31 is further extended to outside of the acoustic mirror cavity 20 and maintains the electrical contact with the first bottom electrode 30 on a pin side. In this way, the resistance is further reduced while a more reliable electrical connection between the first bottom electrode 30 and the second bottom electrode 31 is achieved. In the embodiment shown in Fig. 3, the sidewall is inclined outward relative to the bottom, which is more helpful for the second bottom electrode 31 to extend out of the acoustic mirror cavity 20.

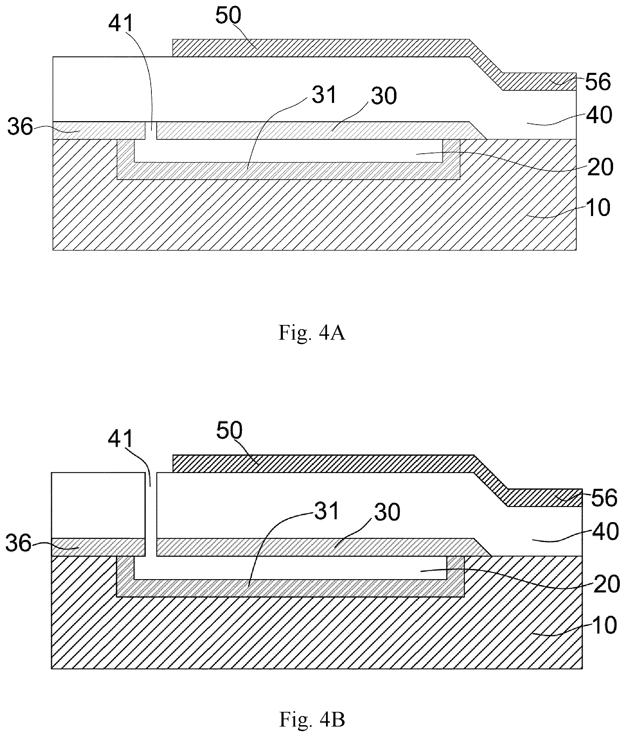

In the present disclosure, in order to further simplify the processing technology, as shown in Fig. 4A, a through hole 41 is formed in a portion of the electrode 30 that is located outside the effective region. In a wet environment, an etchant passes through a relatively loose micro-structure of the piezoelectric layer 40 to enter the cavity 20 through the through hole 41 and gradually decompose sacrificial layer substances therein, and reaction products passes through the piezoelectric layer 40 and are discharged from the resonator through the through hole 41.

In addition, in an embodiment, as shown in Fig. 4B, the through hole 41 penetrates through the electrode layer 30 and the piezoelectric layer 40, which can accelerate the release process of the sacrificial layer and reduce the adverse effects of the etchant on the resonator.

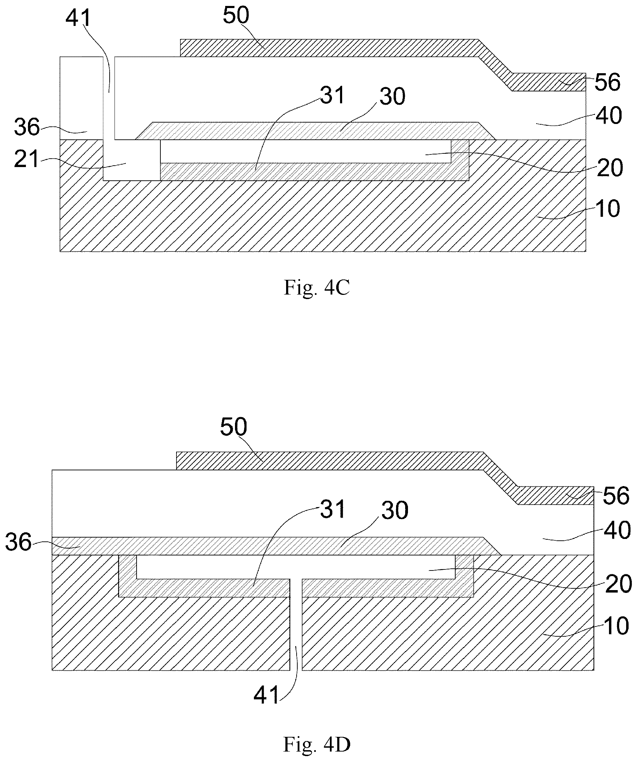

As shown in Fig. 4C, the through hole 41 is formed in a position other than the electrode 30. The through hole communicates with the acoustic mirror cavity through the release channel 21, which is arranged on the same layer as the acoustic mirror cavity, so as to release the acoustic mirror cavity. The second electrode 31 only covers inside of the acoustic mirror cavity, but does not cover the release channel.

As shown in Fig. 4D, the through hole penetrates through the substrate 10 and the electrode 31 to form an etchant channel.

It should be noted that the air gap constitutes a gap layer. In an embodiment, in the present disclosure, the gap layer may be a vacuum gap layer except for the air gap layer, or may be a gap layer filled with other gas media.

In the present disclosure, the numerical range can be not only endpoint values, but also a median or other values between the endpoint values, which are all within the scope of the present disclosure.

In the present disclosure, the "inner side" and "outer side" of a component are determined by which part of the component is closer to the center of the effective region of the resonator in the lateral direction of the resonator. If a side is close to the center of the effective region of the resonator, it is an inner side, and conversely, if a side is far away from the center of the effective region of the resonator, it is an outer side.

As can be appreciated by those skilled in the art, the bulk acoustic wave resonator according to the present disclosure can be used to form a filter.

Based on the above description, the present disclosure provides the following technical solutions:
1. A bulk acoustic wave resonator, including:
   a substrate;
   an acoustic mirror cavity provided in the substrate;
   a bottom electrode;
   a top electrode; and
   a piezoelectric layer provided between the bottom electrode and the top electrode,
   wherein the bottom electrode includes a first bottom electrode and a second bottom electrode, the first bottom electrode is provided above the acoustic mirror cavity, at least part of the second bottom electrode is provided in the acoustic mirror cavity to form a gap between the second bottom electrode and the first bottom electrode, and the second bottom electrode maintains electrical contact with the first bottom electrode.
2. The resonator according to 1, wherein:
   the second bottom electrode covers at least part of a bottom of the acoustic mirror.
3. The resonator according to 2, wherein:
   the acoustic mirror has a sidewall, the second bottom electrode extends from the bottom to be arranged on the sidewall, and the second bottom electrode is in electrical contact with the first bottom electrode.
4. The resonator according to 3, wherein:
   the second bottom electrode further extends from the sidewall to be arranged between the substrate and the first bottom electrode.
5. The resonator according to 3, wherein:
   the sidewall is perpendicular to the bottom.
6. The resonator according to 3, wherein:
   the sidewall is inclined outwards relative to the bottom.
7. The resonator according to 1, wherein:
   the top electrode, the first bottom electrode, the piezoelectric layer and the gap overlap each other to form an overlapping region, and the overlapping region is an effective region of the resonator; and
   at least one through hole is provided outside the effective region of the first bottom electrode, and the through hole communicates with the acoustic mirror cavity.
8. The resonator according to 7, wherein:
   the through hole penetrates through the first bottom electrode and the piezoelectric layer.
9. The resonator according to 1, wherein:
   the substrate is provided with at least one channel arranged at an outer side of the acoustic mirror cavity, the at least one channel communicates with the acoustic mirror cavity, and the at least one channel extends to the outer side of the first bottom electrode in a lateral direction; and
   the resonator further includes at least one through hole that is provided at an outer side of the first bottom electrode and penetrates through the piezoelectric layer, and the at least one through hole is connected to the at least one channel at the outer side of the first bottom electrode to communicate with the at least one channel.
10. The resonator according to 1, wherein:
   the second bottom electrode and the substrate are both provided with at least one through hole, and the at least one through hole communicates with the acoustic mirror cavity.
11. The resonator according to 1, wherein:
   an upper surface of the gap is higher than an upper surface of the substrate.
12. The resonator according to 1, wherein:
   an upper surface of the gap is flush with an upper surface of the substrate.
13. A filter, including the bulk acoustic wave resonator according to any one of 1-12.
14. An electronic device, including the filter according to 13 or the resonator according to any one of 1-12.

Although the embodiments of the present disclosure have been shown and described, it will be understood by those skilled in the art that changes can be made to these embodiments without departing from the principles and spirit of the present disclosure, and the scope of the present disclosure is determined by the appended claims and their equivalents.

## Claims

1. A bulk acoustic wave resonator, comprising:
a substrate;
an acoustic mirror cavity provided in the substrate;
a bottom electrode;
a top electrode; and
a piezoelectric layer provided between the bottom electrode and the top electrode,
wherein the bottom electrode comprises a first bottom electrode and a second bottom electrode, the first bottom electrode is provided above the acoustic mirror cavity, at least part of the second bottom electrode is provided in the acoustic mirror cavity to form a gap between the second bottom electrode and the first bottom electrode, and the second bottom electrode maintains electrical contact with the first bottom electrode.

2. The resonator according to claim 1, wherein the second bottom electrode covers at least part of a bottom of the acoustic mirror.

3. The resonator according to claim 2, wherein the acoustic mirror has a sidewall, the second bottom electrode extends from the bottom to be arranged on the sidewall, and the second bottom electrode is in electrical contact with the first bottom electrode.

4. The resonator according to claim 3, wherein the second bottom electrode further extends from the sidewall to be arranged between the substrate and the first bottom electrode.

5. The resonator according to claim 3, wherein the sidewall is perpendicular to the bottom.

6. The resonator according to claim 3, wherein the sidewall is inclined outwards relative to the bottom.

7. The resonator according to claim 1, wherein the top electrode, the first bottom electrode, the piezoelectric layer and the gap overlap each other to form an overlapping region, and the overlapping region is an effective region of the resonator; and
at least one through hole is provided outside the effective region of the first bottom electrode, and the at least one through hole communicates with the acoustic mirror cavity.

8. The resonator according to claim 7, wherein the through hole penetrates through the first bottom electrode and the piezoelectric layer.

9. The resonator according to claim 1, wherein the substrate is provided with at least one channel arranged at an outer side of the acoustic mirror cavity, the at least one channel communicates with the acoustic mirror cavity, and the at least one channel extends to an outer side of the first bottom electrode in a lateral direction; and
the resonator further comprises at least one through hole that is provided at the outer side of the first bottom electrode and penetrates through the piezoelectric layer, and the at least one through hole is connected to the at least one channel at the outer side of the first bottom electrode to communicate with the at least one channel.

10. The resonator according to claim 1, wherein the second bottom electrode and the substrate are both provided with at least one longitudinal through hole, and the at least one longitudinal through hole communicates with the acoustic mirror cavity.

11. The resonator according to claim 1, wherein an upper surface of the gap is higher than an upper surface of the substrate.

12. The resonator according to claim 1, wherein an upper surface of the gap is flush with an upper surface of the substrate.

13. A filter, comprising the bulk acoustic wave resonator according to any one of clams 1-12.

14. An electronic device, comprising the filter according to claim 13 or the resonator according to any one of claims 1-12.
